(19) Europäisches Patentamt / European Patent Office / Office européen des brevets

(11) **EP 4 474 839 A1**

(12) **EUROPEAN PATENT APPLICATION**
published in accordance with Art. 153(4) EPC

(43) Date of publication:
**11.12.2024 Bulletin 2024/50**

(21) Application number: 23749617.9

(22) Date of filing: **25.01.2023**

(51) International Patent Classification (IPC):
*G01R 31/392* (2019.01)    *G01R 31/379* (2019.01)
*G01R 31/3828* (2019.01)    *H01M 10/48* (2006.01)
*H02J 7/00* (2006.01)

(52) Cooperative Patent Classification (CPC):
G01R 31/379; G01R 31/3828; G01R 31/392;
H01M 10/48; H02J 7/00; Y02E 60/10

(86) International application number:
**PCT/JP2023/002257**

(87) International publication number:
**WO 2023/149301 (10.08.2023 Gazette 2023/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **03.02.2022 JP 2022015639**

(71) Applicants:
• **FURUKAWA ELECTRIC CO., LTD.**
**Tokyo 100-8322 (JP)**
• **The Furukawa Battery Co., Ltd.**
**Yokohama-shi, Kanagawa-ken 240-0006 (JP)**

(72) Inventors:
• **NAKAMURA Hideto**
**Tokyo 100-8322 (JP)**
• **TANIMURA Yudai**
**Tokyo 100-8322 (JP)**
• **KUTSUMA Ayaka**
**Tokyo 100-8322 (JP)**
• **SATO Toshiyuki**
**Yokohama-shi, Kanagawa 240-0006 (JP)**
• **YOSHIDA Hideaki**
**Nikko-shi, Tochigi 321-2336 (JP)**

(74) Representative: **Grünecker Patent- und Rechtsanwälte PartG mbB Leopoldstraße 4 80802 München (DE)**

(54) **LEAD-ACID STORAGE BATTERY SYSTEM, AND LEAD-ACID STORAGE BATTERY LIFE ESTIMATION METHOD**

(57) Provided are a lead-acid battery system and a lead-acid battery life estimation method capable of accurately estimating a remaining life of a lead-acid battery by calculating a capacity turnover value during operation in consideration of a magnitude of a depth of discharge (DOD). The lead-acid battery system (S) estimates the remaining life of the lead-acid battery (B) by comparing a capacity turnover value from the beginning to the end of life with the capacity turnover value during operation. The lead-acid battery system (S) includes a capacity turnover value calculation unit (137) that calculates the capacity turnover value during operation. The capacity turnover value calculation unit (137) calculates the capacity turnover value during operation by using a DOD-based correction coefficient Kdod(c) calculated based on the DOD representing the depth of discharge calculated by dividing an integrated discharge capacity after the start of the discharge of the lead-acid battery (B) by a rated capacity of the lead-acid battery (B).

(Cont. next page)

# FIG. 4

FROM DISCHARGE END
DETERMINATION UNIT

137

CAPACITY TURNOVER VALUE
CALCULATION UNIT

PREVIOUS CAPACITY TURNOVER
VALUE ACQUISITION UNIT — 137a

INTEGRATED DISCHARGE CAPACITY
ACQUISITION UNIT — 137b

RATED CAPACITY ACQUISITION UNIT — 137c

DOD CALCULATION UNIT — 137d

DOD-BASED CORRECTION
COEFFICIENT CALCULATION UNIT — 137e

FROM
RECORDING
UNIT

CAPACITY TURNOVER VALUE
COMPUTATION UNIT — 137f

TO LIFE ESTIMATION UNIT

**Description**

Technical Field

The present invention relates to a lead-acid battery system and a lead-acid battery life estimation method for estimating a remaining life of a lead-acid battery.

Background Art

In recent years, power generation facilities using natural energy such as sunlight and wind power have increased. In such a power generation facility, the amount of power generated cannot be controlled, and thus a storage battery is used to level the power load. That is, when the amount of power generation is larger than the amount of consumption, the difference is charged into storage batteries, and when the amount of power generation is smaller than the amount of consumption, the difference is discharged from the storage batteries.

Examples of such storage batteries include lead-acid batteries and lithium-ion secondary batteries. These storage batteries for power storage are installed in houses, offices, and sites of factories, electric power companies, and the like. The storage batteries are assumed to be used in units of several years to 10 years from the start of operation.

When long-term use is assumed as described above, it is necessary to periodically perform maintenance and management (maintenance) after the start of operation. This is because in a case of various storage batteries as described above, it is known that deterioration progresses with use and available battery capacity decreases. These storage batteries are not replaced immediately when their capacity is depleted after a single discharge unlike primary batteries, but are repeatedly used. Thus, it is required to appropriately grasp the state of installed storage batteries.

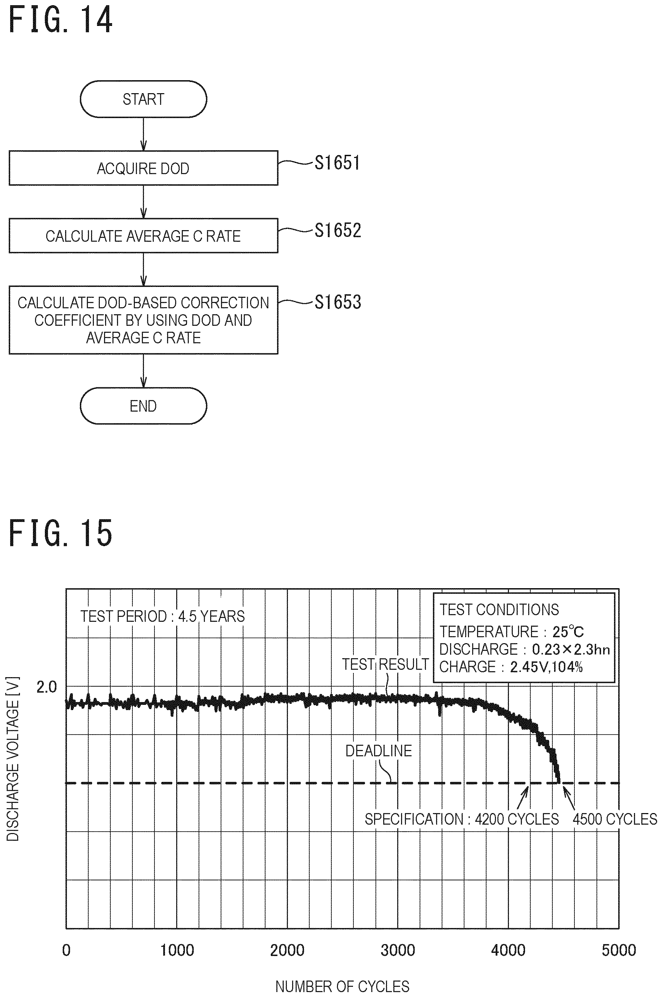

Here, an example of a cycle characteristic of a general lead-acid battery will be described. As illustrated in FIG. 15, a decrease in capacity of the lead-acid battery due to deterioration occurs, for example, from around 3900 cycles with respect to 4500 cycles of life, and there is a possibility that a characteristic change is not observed until the end of the life of the lead-acid battery.

A main factor of the decrease in capacity of the lead-acid battery is a decrease in adhesion between a positive electrode grid and an active material. From the viewpoint of energy density, in a bipolar lead-acid battery that has attracted attention in recent years, there is a possibility that a further rapid decrease in capacity may occur toward the end of life.

In view of the possibility that a characteristic change (capacity decrease) is not observed until the end of the life of the lead-acid battery as described above, it has been hitherto performed to estimate the life of the lead-acid battery from a capacity turnover value (CT value), which is an index related to the number of discharges.

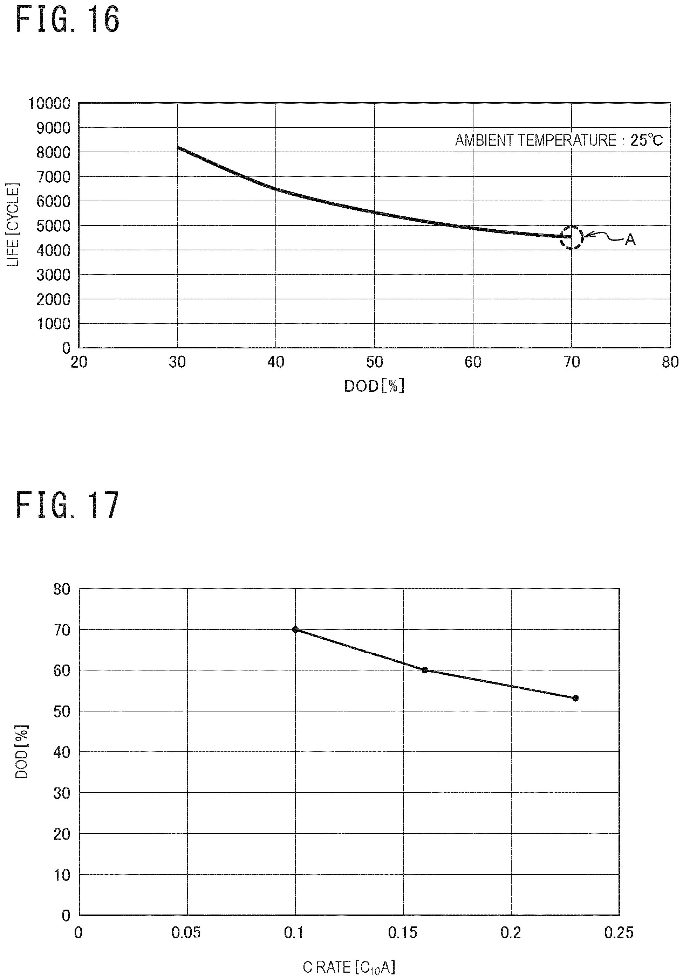

Here, the capacity turnover value is a value obtained by dividing the total discharge capacity by a rated capacity of the storage battery, and is used as a life index of the storage battery. In a cycle charge/discharge lead-acid battery, the number of discharges (cycle life) from the beginning to the end of life is obtained under certain conditions, and the capacity turnover value from the beginning to the end of life can be calculated. FIG. 16 illustrates an example of a relationship between a DOD representing a depth of discharge and the life of the storage battery. In a case where a lead-acid battery having a rated capacity of 1000 Ah as indicated by an arrow A is dischargeable for 4500 cycles with a DOD of 70%, the capacity turnover value from the beginning to the end of life is total discharge capacity (1000 Ah $\times$ 70% $\times$ 4500 cycles)/rated capacity (1000 Ah) = 3150 (times).

Therefore, the remaining life of the lead-acid battery can be estimated by comparing the capacity turnover value from the beginning to the end of life with the capacity turnover value during operation.

On the other hand, as a conventional lead-acid battery life prediction method, for example, a method described in PTL 1 is known.

The lead-acid battery life prediction method described in PTL 1 integrates a charged electricity amount from a charge current value of a lead-acid battery, and predicts a life of the lead-acid battery from the integrated value. In the lead-acid battery life prediction method described in PTL 1, a relationship between a charging battery voltage and a battery temperature and a charging current is measured in advance using a standard lead-acid battery, a charging battery voltage and a battery temperature of a target lead-acid battery are detected, and a charge current value is determined based on the detected values and the above-described relationship.

Citation List

Patent Literature

PTL 1: JP H2-288074 A

# EP 4 474 839 A1

Summary of Invention

Technical Problem

However, in the conventional lead-acid battery life prediction method described in PTL 1, in prediction of a life of a lead-acid battery, a charged electricity amount is integrated from a charge current value of the lead-acid battery, and the life of the lead-acid battery is predicted from the integrated value, and a remaining life of the lead-acid battery is not estimated by comparing the above-described capacity turnover value from the beginning to the end of life and the capacity turnover value during operation. Therefore, it is difficult to accurately estimate the remaining life of the lead-acid battery.

Meanwhile, deterioration factors of a lead-acid battery include softening and sulfation of an active material in addition to deterioration of a positive electrode foil, and a degradation mode of the lead-acid battery due to the softening and sulfation of the active material changes depending on a DOD (a ratio of an integrated discharge capacity with respect to a rated capacity of the storage battery) representing the depth of discharge. The life of the lead-acid battery varies depending on the magnitude of the DOD as illustrated in FIG. 16.

Therefore, it is desirable to consider the magnitude of the DOD in order to calculate the capacity turnover value during operation to estimate the life of the lead-acid battery in consideration of the progress of deterioration due to the softening or sulfation of the active material.

Therefore, an object of the present invention is to provide a lead-acid battery system and a lead-acid battery life estimation method capable of accurately estimating a remaining life of a lead-acid battery by calculating a capacity turnover value during operation in consideration of a magnitude of a DOD.

Solution to Problem

A lead-acid battery system according to an aspect of the present invention is a lead-acid battery system configured to estimate a remaining life of a lead-acid battery by comparing a capacity turnover value from a beginning to an end of life with a capacity turnover value during operation, the lead-acid battery system including a capacity turnover value calculation unit configured to calculate the capacity turnover value during operation, in which the capacity turnover value calculation unit calculates the capacity turnover value during operation by using a depth-of-discharge (DOD)-based correction coefficient calculated based on a DOD representing a depth of discharge calculated by dividing an integrated discharge capacity after a start of a discharge of the lead-acid battery by a rated capacity of the lead-acid battery.

A lead-acid battery life estimation method according to another aspect of the present invention is a lead-acid battery life estimation method in which a remaining life of a lead-acid battery is estimated by comparing a capacity turnover value from a beginning to an end of life with a capacity turnover value during operation, the lead-acid battery life estimation method including a capacity turnover value calculation step of calculating the capacity turnover value during operation, in which in the capacity turnover value calculation step, the capacity turnover value during operation is calculated using a depth-of-discharge (DOD)-based correction coefficient calculated based on a DOD representing a depth of discharge calculated by dividing an integrated discharge capacity after a start of a discharge of the lead-acid battery by a rated capacity of the lead-acid battery.

Advantageous Effects of Invention

In the lead-acid battery system according to the present invention, the capacity turnover value calculation unit calculates the capacity turnover value during operation by using the DOD-based correction coefficient calculated based on the DOD representing the depth of discharge calculated by dividing the integrated discharge capacity after the start of the discharge of the lead-acid battery by the rated capacity of the lead-acid battery. Therefore, it is possible to calculate the capacity turnover value during operation in consideration of a change due to the DOD, to consider the progress of deterioration due to softening or sulfation of an active material in addition to corrosion of a positive electrode foil, and to provide the lead-acid battery system capable of accurately estimating the remaining life of the lead-acid battery.

In addition, in the lead-acid battery system according to the present invention, the capacity turnover value calculation unit calculates the DOD-based correction coefficient by using the DOD and the average C rate obtained by averaging, with a time, C rates each representing a magnitude of a discharge current calculated by dividing a discharge current value when the lead-acid battery is discharged by the rated capacity of the lead-acid battery. Since the DOD varies depending on the C rate representing the magnitude of the discharge current (see FIG. 17), as the DOD-based correction coefficient is calculated using the DOD and the average C rate, the accuracy of the capacity turnover value during operation increases, and it is possible to provide the lead-acid battery system capable of more accurately estimating the remaining life of the lead-acid battery.

In the lead-acid battery system of the present invention, the lead-acid battery is a bipolar lead-acid battery. Accordingly, it is possible to provide the lead-acid battery system capable of accurately estimating the remaining life of the

4

bipolar lead-acid battery.

In the lead-acid battery life estimation method according to the present invention, in the capacity turnover value calculation step, the capacity turnover value during operation is calculated using the DOD-based correction coefficient calculated based on the DOD representing the depth of discharge calculated by dividing the integrated discharge capacity after the start of the discharge of the lead-acid battery by the rated capacity of the lead-acid battery. Therefore, it is possible to calculate the capacity turnover value during operation in consideration of the magnitude of the DOD, to consider the progress of deterioration due to softening or sulfation of an active material in addition to corrosion of a positive electrode foil, and to provide the lead-acid battery system capable of accurately estimating the remaining life of the lead-acid battery.

In addition, in the lead-acid battery life estimation method according to the present invention, in the capacity turnover value calculation step, the DOD-based correction coefficient is calculated using the DOD and the average C rate obtained by averaging, with a time, the C rates each representing the magnitude of the discharge current calculated by dividing the discharge current value when the lead-acid battery is discharged by the rated capacity of the lead-acid battery. Since the DOD varies depending on the C rate representing the magnitude of the discharge current, as the DOD-based correction coefficient is calculated using the DOD and the average C rate, the accuracy of the capacity turnover value during operation increases, and it is possible to provide the lead-acid battery life estimation method capable of more accurately estimating the remaining life of the lead-acid battery.

In the lead-acid battery life estimation method of the present invention, the lead-acid battery is a bipolar lead-acid battery. Accordingly, it is possible to provide the lead-acid battery life estimation method capable of accurately estimating the remaining life of the bipolar lead-acid battery.

Brief Description of Drawings

FIG. 1 is a block diagram illustrating an overall configuration of lead-acid battery systems according to first and second embodiments of the present invention;

FIG. 2 is a block diagram illustrating an internal configuration of battery management units (BMUs) included in the lead-acid battery systems according to the first and second embodiments of the present invention illustrated in FIG. 1;

FIG. 3 is a block diagram illustrating internal configurations of a recording unit and a state determination unit included in the BMU illustrated in FIG. 2 in the lead-acid battery system according to the first embodiment of the present invention;

FIG. 4 is a block diagram illustrating an internal configuration of a capacity turnover value calculation unit included in the state determination unit illustrated in FIG. 3;

FIG. 5 is a flowchart illustrating a flow of processing in the state determination unit illustrated in FIG. 3;

FIG. 6 is a flowchart illustrating a flow of processing of step S8 (capacity turnover value calculation step) in the flowchart illustrated in FIG. 5;

FIG. 7 is a flowchart illustrating a flow of processing of step S75 (depth-of-discharge (DOD)-based correction coefficient calculation step) in the flowchart illustrated in FIG. 6;

FIG. 8 is a diagram for describing a start timing of processing in the state determination unit, an end timing of discharge start determination, and an end timing of discharge end determination in a case where a peak cut/peak shift in which a lead-acid battery is charged at night and discharged at a power peak time in the morning is taken as an example for charge and discharge of the lead-acid battery;

FIG. 9 is a graph illustrating an example of a relationship between the DOD representing the depth of discharge and a DOD-based correction coefficient $K_{dod}(c)$;

FIG. 10 is a block diagram illustrating internal configurations of a recording unit and a state determination unit included in the BMU illustrated in FIG. 2 in the lead-acid battery system according to the second embodiment of the present invention;

FIG. 11 is a block diagram illustrating an internal configuration of a capacity turnover value calculation unit included in the state determination unit illustrated in FIG. 10;

FIG. 12 is a flowchart illustrating a flow of processing in the state determination unit illustrated in FIG. 10;

FIG. 13 is a flowchart illustrating a flow of processing of step S17 (capacity turnover value calculation step) in the flowchart illustrated in FIG. 12;

FIG. 14 is a flowchart illustrating a flow of processing of step S165 (DOD-based correction coefficient calculation step) in the flowchart illustrated in FIG. 13;

FIG. 15 is a graph for describing an example of a cycle characteristic of a general lead-acid battery;

FIG. 16 is a graph illustrating an example of a relationship between the DOD representing the depth of discharge and a life of a storage battery; and

FIG. 17 is a graph illustrating an example of a relationship between a C rate representing a magnitude of a discharge current and the DOD representing the depth of discharge.

Description of Embodiments

Hereinafter, an embodiment of the present invention will be described in detail with reference to the drawings. Note that the embodiment described below illustrates an example of the present invention. In addition, various changes or improvements can be added to the present embodiment, and a mode to which such changes or improvements are added can also be included in the present invention. The embodiment and modifications thereof are included in the scope and gist of the invention, and are included in the scope of the invention described in the claims and its equivalents.

(First Embodiment)

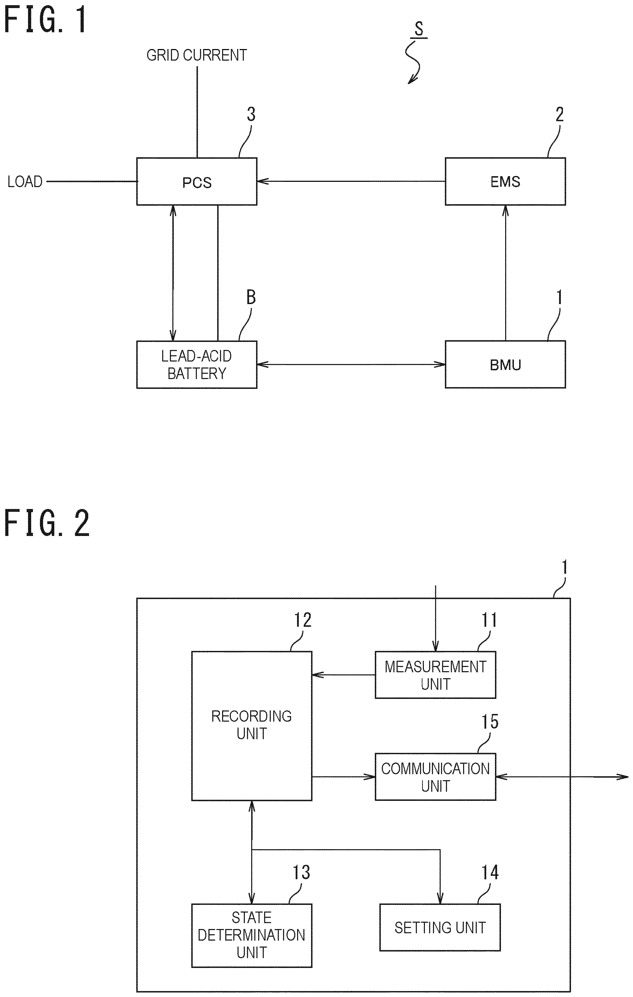

FIG. 1 illustrates an overall configuration of lead-acid battery systems according to a first embodiment of the present invention and a second embodiment described below.

A lead-acid battery system S illustrated in FIG. 1 is a system that stores, in a lead-acid battery B, a grid current generated by various power plants such as thermal power plants or from renewable energy such as wind power generation and transmitted, and transmits the power stored in the lead-acid battery B to a load such as a home, an office, or a factory as necessary. The lead-acid battery system S includes a BMU 1, an EMS 2, and a PCS 3 in addition to the lead-acid battery B.

The BMU 1 is a battery management unit and is a device that manages a voltage of each of cells included in the lead-acid battery B, a temperature of the entire lead-acid battery B, and the like. Thus, the BMU 1 can grasp a state of the lead-acid battery B via a sensor that is provided in the lead-acid battery B and acquires various types of information.

In addition, the BMU 1 estimates a remaining life of the lead-acid battery B by comparing a capacity turnover value from the beginning to the end of life with a capacity turnover value during operation. Therefore, the BMU 1 includes a life estimation program necessary for the estimation.

Note that a function of the BMU 1 is not limited to the function described here, and may include other functions such as managing the balance of voltages in the respective cells, for example.

The BMU 1 is a computer system having an arithmetic processing function, and can implement each function on software by executing various dedicated computer programs stored in advance in hardware. In addition, the BMU 1 may be installed near the lead-acid battery B, or may be configured to be managed on a cloud or managed remotely. A detailed configuration of the BMU 1 will be described later.

The EMS 2 is a so-called energy management system, and is a system that grasps, manages, and optimizes a use state of power energy. In addition, the PCS 3 is a power conditioning system, and serves a role of converting a direct current generated from a grid current or the like into an alternating current and adjusting the alternating current to an output to the load or a stable output suitable for storage in the lead-acid battery B.

The lead-acid battery B is a secondary battery using lead as an electrode. As the lead-acid battery B, a bipolar lead-acid battery is preferably applied, but any structure may be used, and the number of installations, an installation method, and the like are not limited, and any setting can be used. In the lead-acid battery B, information acquired from various sensors to be described later (sensor information) is transmitted to the BMU 1, but a transmission/reception device or the like for transmitting the acquired sensor information to the BMU 1 and receiving, for example, a command from the PCS 3 is provided.

The lead-acid battery B includes various sensors (not illustrated in FIG. 1) for acquiring corresponding operation history information. The various sensors are sensors that acquire information indicating an operation history or state of the lead-acid battery B such as a current, a voltage, or a temperature. These sensors may be provided for each unit or for each individual lead-acid battery B.

In the lead-acid battery system S according to the first embodiment and the second embodiment described below, the direct current from the grid current from the power plant such as a thermal power plant or renewable energy is converted into the alternating current in the PCS 3, and output to the load or storage in the lead-acid battery B is performed.

As will be described later, the BMU 1 estimates the remaining life of the lead-acid battery B, grasps a charge rate, the degree of deterioration, and the like of the lead-acid battery B, and issues an operation command to the EMS 2 according to the state of the lead-acid battery B. This operation command is further transmitted to the PCS 3 to appropriately issue a command for charging or discharging the lead-acid battery B and perform the above-described output to the load and the like.

As illustrated in FIG. 1, the BMU 1, the EMS 2, the PCS 3, and the lead-acid battery B are exemplified as four constituent elements of the lead-acid battery system S, but the constituent elements of the lead-acid battery system S are not limited thereto. It is also possible to impart the functions of the EMS 2 and the PCS 3 to the BMU 1, and in this case, the lead-acid battery system S is constituted by the BMU 1 and the lead-acid battery B.

Next, the BMU 1 will be described in more detail. FIG. 2 is a block diagram illustrating an internal configuration of the BMUs included in the lead-acid battery systems illustrated in FIG. 1 according to the first embodiment of the present invention and the second embodiment described below.

The BMU 1 includes a measurement unit 11, a recording unit 12, a state determination unit 13, a setting unit 14, and a communication unit 15.

The measurement unit 11 receives information regarding a measured value such as a current, a voltage, or a temperature measured via the above-described various sensors provided in the lead-acid battery B. Note that the measurement unit 11 may be set to continuously receive the above-described information, or may receive the above-described information between two time points arbitrarily set in advance. Alternatively, the measurement unit 11 may be set to periodically receive the information.

The recording unit 12 records information regarding the measured value received from the various sensors by the measurement unit 11, information exchanged with the EMS 2, information necessary for calculating the capacity turnover value during operation and the capacity turnover value from the beginning to the end of life (for example, a rated capacity or the like of the lead-acid battery B), a result of processing executed by the state determination unit 13 (the remaining life of the lead-acid battery B and the capacity turnover value during operation calculated by state determination unit 13), and the like.

The state determination unit 13 determines the state of the lead-acid battery B, specifically, estimates the remaining life of the lead-acid battery B by comparing the capacity turnover value from the beginning to the end of life and the capacity turnover value during operation. Here, as described above, the capacity turnover value is a value obtained by dividing a total discharge capacity by a rated capacity of a storage battery, and is used as a life index of the storage battery. The capacity turnover value from the beginning to the end of life is obtained by dividing the total discharge capacity from the beginning to the end of life by the rated capacity of the storage battery. For example, in FIG. 16, when a lead-acid battery having a rated capacity of 1000 Ah as indicated by an arrow A is dischargeable for 4500 cycles with a DOD of 70%, the capacity turnover value from the beginning to the end of life (hereinafter, referred to as a CT value from the beginning to the end of life) is total discharge capacity (1000 Ah × 70% × 4500 cycles)/rated capacity (1000 Ah) = 3150 (times). In addition, the capacity turnover value during operation is calculated by a method described below.

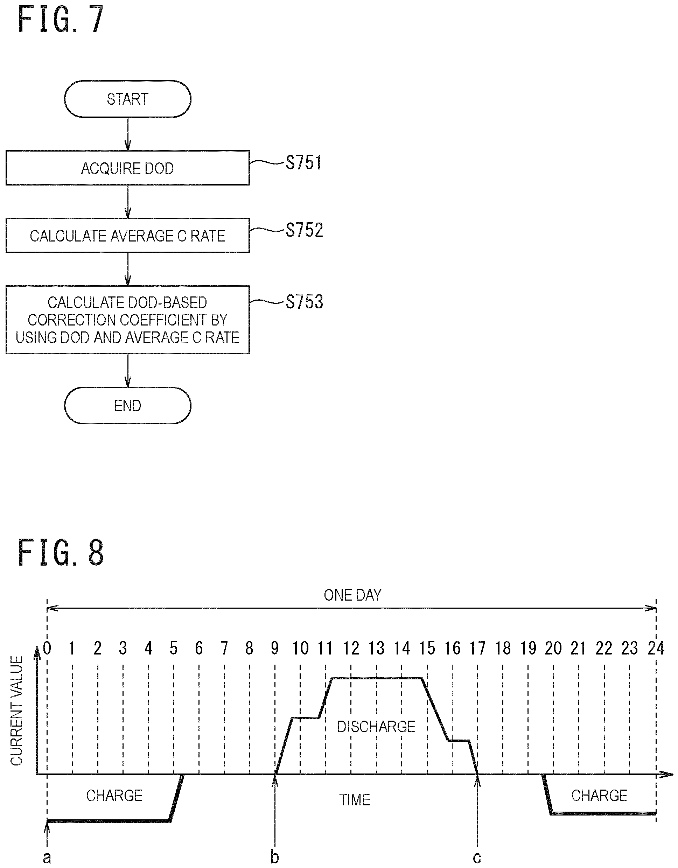

The processing in the state determination unit 13 is executed as needed in normal operation, for example. In the processing in the state determination unit 13, for example, as illustrated in FIG. 8, a start timing a of the processing in the state determination unit is during the charge of the lead-acid battery B in a case where a peak cut/peak shift in which the lead-acid battery B is charged at night and discharged at a power peak time in the morning is taken as an example for charge and discharge of the lead-acid battery B. In FIG. 8, an end timing b of discharge start determination by the state determination unit 13 is when the discharge of the lead-acid battery B starts, and an end timing c of discharge end determination is when the discharge of the lead-acid battery B ends.

The setting unit 14 sets, for example, a threshold or the like of a current value used for the discharge start determination and the discharge end determination, which is used when the state determination unit 13 determines the state of the lead-acid battery B, specifically, estimates the remaining life of the lead-acid battery B, and transmits the set information to the recording unit 12. In setting the threshold, an input unit and a display unit (not illustrated in FIG. 2) are used.

The communication unit 15 transmits the result of the processing in the state determination unit 13 recorded in the recording unit 12 to the EMS 2.

The BMU 1 is a computer system having an arithmetic processing function as described above and has a configuration in which a central processing unit (CPU), a read only memory (ROM), a random access memory (RAM), and an input/output interface are connected via a bus. In addition, the input unit and the display unit used by a person who manages the lead-acid battery system S are connected to the input/output interface, and each unit illustrated in FIG. 2 described above is connected to the input/output interface.

The CPU reads and executes a boot program for activating the BMU 1 from the ROM based on an input signal from the input unit, and reads various operating systems stored in the recording unit 12. The CPU may control the lead-acid battery B or the like based on an input signal from another external device (not illustrated in FIG. 2) via the input unit or the input/output interface.

Further, the CPU is a processing device that reads a program and data stored in the RAM, the recording unit 12, or the like and loads the program and the data into the RAM, and implements a series of processing such as calculation and processing of data necessary for estimating the remaining life of the lead-acid battery B based on a command of the program read from the RAM.

The input unit is implemented by an input device such as a touch panel to which a person who manages the lead-acid battery system S inputs various operations, and an input signal is created based on the operation of the manager and transmitted to the CPU via the bus.

The display unit is, for example, a liquid crystal display. The display unit receives an output signal from the CPU via the bus and displays a processing result of the CPU.

In a case where the BMU 1 itself is operated by remote control, for example, the input unit and the display unit do not have to be provided inside the BMU 1. The BMU 1 may have functions other than the above-described units.

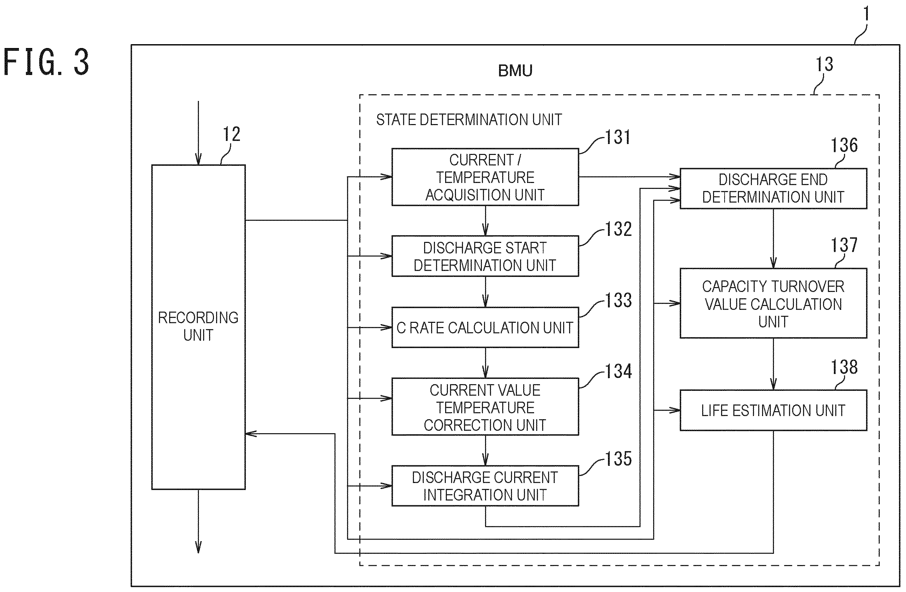

Next, internal configurations of the recording unit 12 and the state determination unit 13 will be described in more detail below. FIG. 3 is a block diagram illustrating the internal configurations of the recording unit 12 and the state determination unit 13 included in the BMU 1 illustrated in FIG. 2 in the lead-acid battery system S according to the first embodiment of the present invention.

The recording unit 12 is implemented by, for example, a semiconductor or a magnetic disk. The recording unit 12 records information regarding the measured value received from the various sensors by the measurement unit 11, such as information regarding a current value and a voltage value when the lead-acid battery B is charged or discharged, or information regarding the temperature of the lead-acid battery B, information exchanged with the EMS 2, information necessary for calculating the capacity turnover value during operation and the capacity turnover value from the beginning to the end of life (for example, the rated capacity or the like of the lead-acid battery B), a result of processing executed by the state determination unit 13 (the remaining life of the lead-acid battery B and the capacity turnover value during operation calculated by state determination unit 13), and the like.

The state determination unit 13 includes a current/temperature acquisition unit 131, a discharge start determination unit 132, a C rate calculation unit 133, a current value temperature correction unit 134, a discharge current integration unit 135, a discharge end determination unit 136, a capacity turnover value calculation unit 137, and a life estimation unit 138.

The current/temperature acquisition unit 131 acquires information regarding the current value and the temperature of the lead-acid battery B input to the recording unit 12 via the measurement unit 11 from the recording unit 12 from the start to the end of the processing in the state determination unit 13. For example, in the example illustrated in FIG. 8, the start timing a of the processing in the state determination unit 13 is during the charge of the lead-acid battery B. In the example illustrated in FIG. 8, the processing in the state determination unit 13 ends after the end timing c of the discharge end determination.

In addition, the discharge start determination unit 132 determines whether or not the discharge of the lead-acid battery B has started based on the current value of the lead-acid battery B acquired by the current/temperature acquisition unit 131. Specifically, it is determined that the discharge has started in a case where the current value of the lead-acid battery B acquired by the current/temperature acquisition unit 131 is smaller than the threshold, and it is determined that the lead-acid battery B is in a charge state in a case where the current value is equal to or larger than the threshold. The threshold is specifically 0 amperes, and it is determined that the discharge has started in a case where the current value of the lead-acid battery B is a negative current, and it is determined that the lead-acid battery B is in the charge state in a case where the current value of the lead-acid battery B is 0 or a positive current. The threshold for the discharge start determination is set by the setting unit 14 and recorded in the recording unit 12, and the discharge start determination unit 132 acquires information regarding the threshold from the recording unit 12.

After the discharge start determination unit 132 determines that the discharge of the lead-acid battery B has started, the C rate calculation unit 133 calculates a C rate from the current value of the lead-acid battery B acquired by the current/temperature acquisition unit 131.

The C rate represents a magnitude of a discharge current and is calculated by dividing the current value of the lead-acid battery B acquired by the current/temperature acquisition unit 131 by the rated current of the lead-acid battery B. Information regarding the rated current of the lead-acid battery B is recorded in the recording unit 12, and the C rate calculation unit 133 acquires the information regarding the rated current from the recording unit 12.

In addition, since the life of the lead-acid battery B changes depending on the temperature of the lead-acid battery B, the current value temperature correction unit 134 corrects the current value of the lead-acid battery B acquired by the current/temperature acquisition unit 131 according to the temperature.

Specifically, 25°C is set as a reference temperature, and it is assumed that in a case where the temperature rises by 10° in accordance with the Arrhenius equation, deterioration is accelerated two times as compared with 25°C (equivalent to that the discharge current is doubled).

Then, the current value of the lead-acid battery B acquired by the current/temperature acquisition unit 131 is corrected based on the following formula: current value after temperature correction = current value × temperature correction coefficient. Here, the temperature correction coefficient is calculated by the following Formula (1).
[Mathematical Formula 1]

$$\text{Temperature correction coefficient} = \text{Storage battery coefficient} \times 2^{\frac{\text{Temperature in storage} - 25^{\circ}\text{C}}{10}} \quad \cdots (1)$$

A storage battery coefficient is a correction value for each storage battery, and is usually set to 1.
Further, the discharge current integration unit 135 integrates the current values corrected by the current value temperature correction unit 134 after the start of the discharge of the lead-acid battery B, and calculates an integrated discharge capacity value after the start of the discharge of the lead-acid battery B.

In addition, the discharge end determination unit 136 determines whether or not the discharge of the lead-acid battery B has ended based on the current value of the lead-acid battery B acquired by the current/temperature acquisition unit 131. Specifically, in a case where the current value of the lead-acid battery B acquired by the current/temperature acquisition unit 131 is equal to or larger than a threshold, it is determined that the lead-acid battery B is in the charge state and the discharge has ended, and in a case where the current value is smaller than the threshold, it is determined that the lead-acid battery B is in a discharge state. The threshold is the same as the threshold used by discharge start determination unit 132.

Next, in a case where it is determined by the discharge end determination unit 136 that the discharge of the lead-acid battery B has ended, the capacity turnover value calculation unit 137 calculates the capacity turnover value during operation (hereinafter, referred to as a CT value during operation).

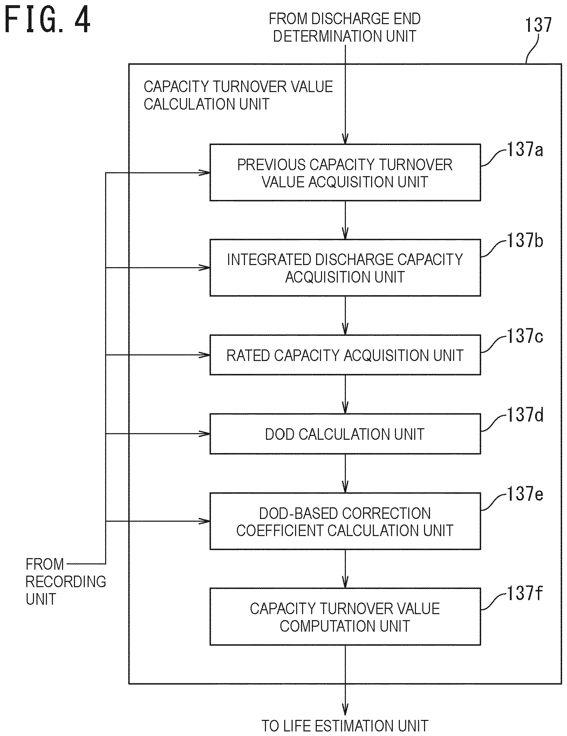

An internal configuration of the capacity turnover value calculation unit 137 will be described in more detail below. FIG. 4 is a block diagram illustrating the internal configuration of the capacity turnover value calculation unit 137 included in the state determination unit 13 illustrated in FIG. 3.

The capacity turnover value calculation unit 137 includes a previous capacity turnover value acquisition unit 137a, an integrated discharge capacity acquisition unit 137b, a rated capacity acquisition unit 137c, a DOD calculation unit 137d, a DOD-based correction coefficient calculation unit 137e, and a capacity turnover value computation unit 137f.

In a case where it is determined by the discharge end determination unit 136 that the discharge of the lead-acid battery B has ended, the previous capacity turnover value acquisition unit 137a acquires a capacity turnover value before the start of the processing in the state determination unit 13 (before the start timing a of the processing in the state determination unit 13 in the example illustrated in FIG. 8) (hereinafter, referred to as a previous CT value) from the recording unit 12. The previous CT value is a CT value during operation calculated by the capacity turnover value calculation unit 137 at the time of the previous processing in the state determination unit 13, and already input from the capacity turnover value calculation unit 137 to the recording unit 12.

In addition, the integrated discharge capacity acquisition unit 137b acquires information regarding the integrated discharge capacity value from the start of the discharge of the lead-acid battery B calculated by the discharge current integration unit 135.

Further, the rated capacity acquisition unit 137c acquires information regarding the rated capacity (Ah) of the lead-acid battery B from the recording unit 12.

In addition, the DOD calculation unit 137d calculates the DOD from the integrated discharge capacity after the start of the discharge of the lead-acid battery B acquired by the integrated discharge capacity acquisition unit 137b and the rated capacity of the lead-acid battery B acquired by the rated capacity acquisition unit 137c based on the following formula: DOD = integrated discharge capacity/rated capacity × 100%. The DOD represents the depth of discharge calculated by dividing the integrated discharge capacity after the start of the discharge of the lead-acid battery B by the rated capacity of the lead-acid battery B.

The DOD-based correction coefficient calculation unit 137e calculates a DOD-based correction coefficient Kdod(c) based on the DOD calculated by the DOD calculation unit 137d.

The DOD-based correction coefficient Kdod(c) is calculated by the following Formula (2) using the DOD calculated by the DOD calculation unit 137d and an average C rate obtained by averaging the C rates calculated by the C rate calculation unit 133 with a discharge time.

[Mathematical Formula 2]

$$K_{dod}(c) = \exp\left(\alpha \times \frac{d \times \varepsilon}{\gamma \times \log_{10} c + \delta}\right) - \beta \quad \cdots \quad (2)$$

Here, in Formula (2), c is the average C rate, d is the DOD, $\alpha$ is 0.0267, $\beta$ is 70, $\gamma$ is 22.790, and $\varepsilon$ is 70.

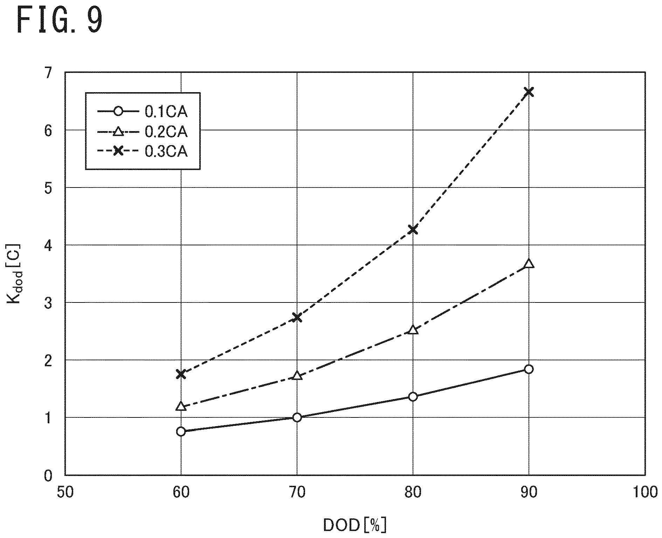

FIG. 9 illustrates an example of a relationship between the DOD representing the depth of discharge and the DOD-based correction coefficient Kdod(c), and the DOD-based correction coefficient Kdod(c) changes depending on magnitudes of the DOD and the C rate. In FIG. 9, 0.1CA, 0.2CA, and 0.3CA indicate the C rates.

Further, the capacity turnover value computation unit 137f calculates the CT value during operation by the following Formula (3) using the previous CT value acquired by the previous capacity turnover value acquisition unit 137a, the integrated discharge capacity after the start of the discharge of the lead-acid battery B acquired by the integrated discharge capacity acquisition unit 137b, the rated capacity (Ah) acquired by the rated capacity acquisition unit 137c, and the DOD-based correction coefficient Kdod(c) calculated by the DOD-based correction coefficient calculation unit 137e.

[Mathematical Formula 3]

$$\text{CT value during operation} = \text{Previous CT value} + \frac{\text{Integrated discharge capacity}}{\text{Rated capacity (Ah)}} \times K_{dod}(c) \cdots (3)$$

Then, the life estimation unit 138 of the state determination unit 13 estimates the remaining life of the lead-acid battery B by comparing the CT value from the beginning to the end of life acquired from the recording unit 12 with the CT value during operation calculated by the capacity turnover value calculation unit 137. That is, the life estimation unit 138 estimates the remaining life of the lead-acid battery B from a CT value obtained by subtracting the CT value during operation from the CT value from the beginning to the end of life.

Then, the life estimation unit 138 records an estimation result of the life estimation unit 138 including the CT value during operation in the recording unit 12.

As described above, in the lead-acid battery system S according to the first embodiment, the capacity turnover value calculation unit 137 calculates the capacity turnover value during operation by using the DOD-based correction coefficient Kdod(c) calculated based on the DOD representing the depth of discharge calculated by dividing the integrated discharge capacity after the start of the discharge of the lead-acid battery B by the rated capacity of the lead-acid battery B. As a result, it is possible to calculate the capacity turnover value during operation in consideration of the magnitude of the DOD, to consider the progress of deterioration due to softening or sulfation of an active material in addition to corrosion of a positive electrode foil, and to accurately estimate the remaining life of the lead-acid battery B.

In addition, in the lead-acid battery system S according to the first embodiment, the capacity turnover value calculation unit 137 calculates the DOD-based correction coefficient Kdod(c) by using the above-described DOD and the average C rate obtained by averaging, with the discharge time, the C rates each representing the magnitude of the discharge current calculated by dividing a discharge current value when the lead-acid battery B is discharged by the rated capacity of the lead-acid battery B. As illustrated in FIG. 17, since the DOD varies depending on the C rate representing the magnitude of the discharge current, as the DOD-based correction coefficient Kdod(c) is calculated using the DOD and the average C rate, the accuracy of the capacity turnover value during operation increases, and the remaining life of the lead-acid battery B can be more accurately estimated.

In the lead-acid battery system S according to the first embodiment, in a case where the lead-acid battery B is a bipolar lead-acid battery, it is possible to provide the lead-acid battery system S capable of accurately estimating the remaining life of the bipolar lead-acid battery.

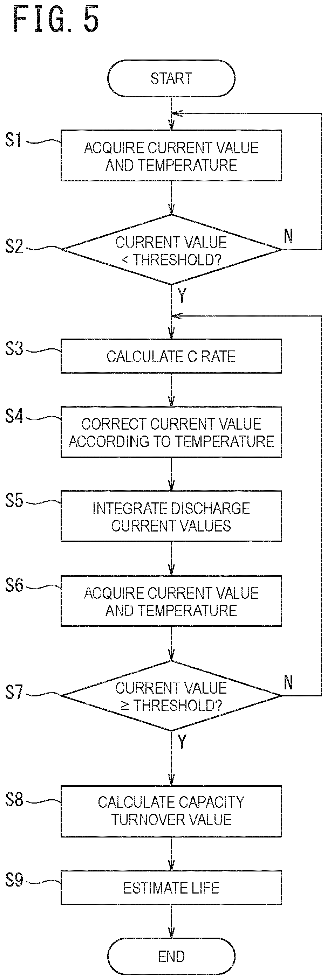

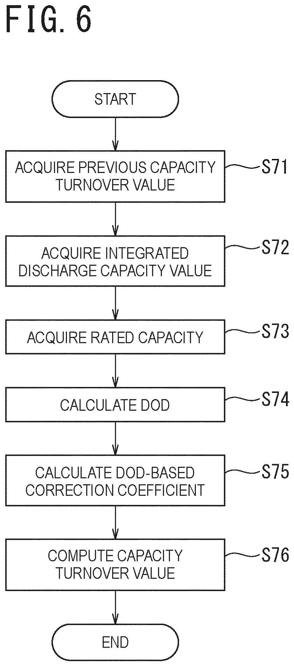

Next, a lead-acid battery life estimation method according to the first embodiment will be described with reference to a flowchart illustrating a flow of processing in the state determination unit illustrated in FIG. 5, a flowchart illustrating a flow of processing of step S8 (capacity turnover value calculation step) in the flowchart of FIG. 5 illustrated in FIG. 6, and a flowchart illustrating a flow of processing of step S75 (DOD-based correction coefficient calculation step) in the flowchart of FIG. 6 illustrated in FIG. 7.

For example, the state determination unit 13 starts the processing from the start timing a in FIG. 8, and as illustrated in FIG. 5, first, in step S1, the current/temperature acquisition unit 131 of the state determination unit 13 acquires, from the recording unit 12, information regarding the current value and the temperature of the lead-acid battery B input to the recording unit 12 via the measurement unit 11 from the start to the end of the processing in the state determination unit 13 (current value/temperature acquisition step).

Next, in step S2, the discharge start determination unit 132 of the state determination unit 13 determines whether or not the discharge of the lead-acid battery B has started based on the current value of the lead-acid battery B acquired in step S1 (discharge start determination step). Specifically, in a case where the current value of the lead-acid battery B acquired in step S1 is smaller than the threshold, it is determined that the discharge has started, and in a case where the current value is equal to or larger than the threshold, it is determined that the lead-acid battery B is in the charge state. The threshold is specifically 0 amperes, and it is determined that the discharge has started in a case where the current value of the lead-acid battery B is a negative current, and it is determined that the lead-acid battery B is in the charge state in a case where the current value of the lead-acid battery B is 0 or a positive current. The threshold for the discharge start determination is set by the setting unit 14 and recorded in the recording unit 12, and the discharge start determination unit 132 acquires information regarding the threshold from the recording unit 12.

In a case where the determination result in step S2 is YES (in a case where it is determined that the discharge has started), the processing proceeds to step S3, and in a case where the determination result is NO, the processing returns to step S1.

In step S3, the C rate calculation unit 133 of the state determination unit 13 calculates the C rate from the current value of the lead-acid battery B acquired in step S1 (C rate calculation step).

As described above, the C rate represents the magnitude of the discharge current, and is calculated by dividing the current value of the lead-acid battery B acquired in step S1 by the rated current of the lead-acid battery B. Information regarding the rated current of the lead-acid battery B is recorded in the recording unit 12, and the C rate calculation unit 133 acquires the information regarding the rated current from the recording unit 12.

Next, in step S4, since the life of the lead-acid battery B changes depending on the temperature of the lead-acid battery B, the current value temperature correction unit 134 of the state determination unit 13 corrects the current value of the lead-acid battery B acquired in step S1 according to the temperature (current value temperature correction step).

Next, in step S5, the discharge current integration unit 135 of the state determination unit 13 integrates the current values corrected in step S4 after the start of the discharge of the lead-acid battery B, and calculates the integrated discharge capacity value after the start of the discharge of the lead-acid battery B (integrated discharge capacity calculation step).

Next, in step S6, the current/temperature acquisition unit 131 of the state determination unit 13 again acquires the information regarding the current value and the temperature of the lead-acid battery B input to the recording unit 12 via the measurement unit 11 from the recording unit 12 (current value/temperature acquisition step).

Next, in step S7, the discharge end determination unit 136 of the state determination unit 13 determines whether or not the discharge of the lead-acid battery B has ended based on the current value of the lead-acid battery B acquired in step S6 (discharge end determination step). Specifically, in a case where the current value of the lead-acid battery B acquired in step S6 is equal to or larger than the threshold, it is determined that the lead-acid battery B is in the charge state and the discharge has ended, and in a case where the current value is smaller than the threshold, it is determined that the lead-acid battery B is in the discharge state. The threshold is the same as the threshold used in step S2.

In a case where the determination result in step S7 is YES (in a case where it is determined that the discharge has ended), the processing proceeds to step S8, and in a case where the determination result is NO, the processing returns to step S3.

In step S8, the capacity turnover value calculation unit 137 of the state determination unit 13 calculates the capacity turnover value during operation (hereinafter, referred to as the CT value during operation) (capacity turnover value calculation step).

A detailed flow of the processing of step S8 will be described with reference to FIG. 6.

First, in step S71, the previous capacity turnover value acquisition unit 137a of the capacity turnover value calculation unit 137 acquires the capacity turnover value before the start of the processing in the state determination unit 13 (before the start timing a of the processing in the state determination unit 13 in the example illustrated in FIG. 8) (hereinafter, referred to as the previous CT value) from the recording unit 12 (previous capacity turnover value acquisition step). The previous CT value is a CT value during operation calculated by the capacity turnover value calculation unit 137 at the time of the previous processing in the state determination unit 13, and already input from the capacity turnover value calculation unit 137 to the recording unit 12.

Next, in step S72, the integrated discharge capacity acquisition unit 137b of the capacity turnover value calculation unit 137 acquires information regarding the integrated discharge capacity value after the start of the discharge of the lead-acid battery B calculated in step S5 (integrated discharge capacity value acquisition step).

Next, in step S73, the rated capacity acquisition unit 137c of the capacity turnover value calculation unit 137 acquires information regarding the rated capacity (Ah) of the lead-acid battery B from the recording unit 12.

Next, in step S74, the DOD calculation unit 137d of the capacity turnover value calculation unit 137 calculates the DOD from the integrated discharge capacity after the start of the discharge of the lead-acid battery B acquired in step S72 and the rated capacity of the lead-acid battery B acquired in step S73 based on the following formula: DOD = integrated discharge capacity/rated capacity $\times$ 100% (DOD calculation step). The DOD represents the depth of discharge calculated by dividing the integrated discharge capacity after the start of the discharge of the lead-acid battery B by the rated capacity of the lead-acid battery B.

Next, in step S75, the DOD-based correction coefficient calculation unit 137e of the capacity turnover value calculation unit 137 calculates the DOD-based correction coefficient Kdod(c) based on the DOD calculated in step S74 (DOD-based correction coefficient calculation step).

A detailed flow of the processing of step S75 will be described with reference to FIG. 7.

First, in step S751, the DOD-based correction coefficient calculation unit 137e acquires the DOD calculated in step S74 from the DOD calculation unit 137d (DOD acquisition step).

Next, in step S752, the DOD-based correction coefficient calculation unit 137e calculates the average C rate obtained by averaging the C rates calculated in step S3 with the discharge time (average C rate calculation step).

Next, in step S753, the DOD-based correction coefficient calculation unit 137e calculates the DOD-based correction coefficient Kdod(c) by using the DOD acquired in step S751 and the average C rate calculated in step S752 according to Formula (2) described above.

When the calculation of the DOD-based correction coefficient Kdod(c) is completed, in step S76, the capacity turnover value computation unit 137f calculates the CT value during operation by Formula (3) described above using the previous CT value acquired in step S71, the integrated discharge capacity after the start of the discharge of the lead-acid battery B acquired in step S72, the rated capacity (Ah) acquired in step S73, and the DOD-based correction coefficient Kdod(c) calculated in step S75.

Accordingly, the processing of step S8 ends.

In step S9, the life estimation unit 138 of the state determination unit 13 estimates the remaining life of the lead-acid battery B by comparing the CT value from the beginning to the end of life acquired from the recording unit 12 with the CT value during operation calculated in step S7. That is, the life estimation unit 138 estimates the remaining life of the lead-acid battery B from a CT value obtained by subtracting the CT value during operation from the CT value from the beginning to the end of life.

Then, the life estimation unit 138 records an estimation result of the life estimation unit 138 including the CT value during operation in the recording unit 12.

Accordingly, the processing in the state determination unit 13 ends.

As described above, in the lead-acid battery life estimation method according to the first embodiment, in the capacity turnover value calculation step (step S8), the capacity turnover value during operation is calculated using the DOD-based correction coefficient Kdod(c) calculated based on the DOD representing the depth of discharge calculated by dividing the integrated discharge capacity after the start of the discharge of the lead-acid battery B by the rated capacity of the lead-acid battery B. As a result, it is possible to calculate the capacity turnover value during operation in consideration of the magnitude of the DOD, to consider the progress of deterioration due to softening or sulfation of the active material in addition to corrosion of the positive electrode foil, and to provide the lead-acid battery life estimation method capable of accurately estimating the remaining life of the lead-acid battery B.

In the lead-acid battery life estimation method according to the first embodiment, in the capacity turnover value calculation step (step S8), the DOD-based correction coefficient Kdod(c) is calculated using the DOD and the average C rate obtained by averaging, with the discharge time, the C rates each representing the magnitude of the discharge current calculated by dividing the discharge current value when the lead-acid battery B is discharged by the rated capacity of the lead-acid battery. Since the DOD varies depending on the C rate representing the magnitude of the discharge current, as the DOD-based correction coefficient Kdod(c) is calculated using the DOD and the average C rate, the accuracy of the capacity turnover value during operation increases, and it is possible to provide the lead-acid battery life estimation method capable of more accurately estimating the remaining life of the lead-acid battery B.

In the lead-acid battery life estimation method according to the first embodiment, in a case where the lead-acid battery B is a bipolar lead-acid battery, it is possible to provide a lead-acid battery life estimation method capable of accurately estimating the remaining life of the bipolar lead-acid battery.

(Second Embodiment)

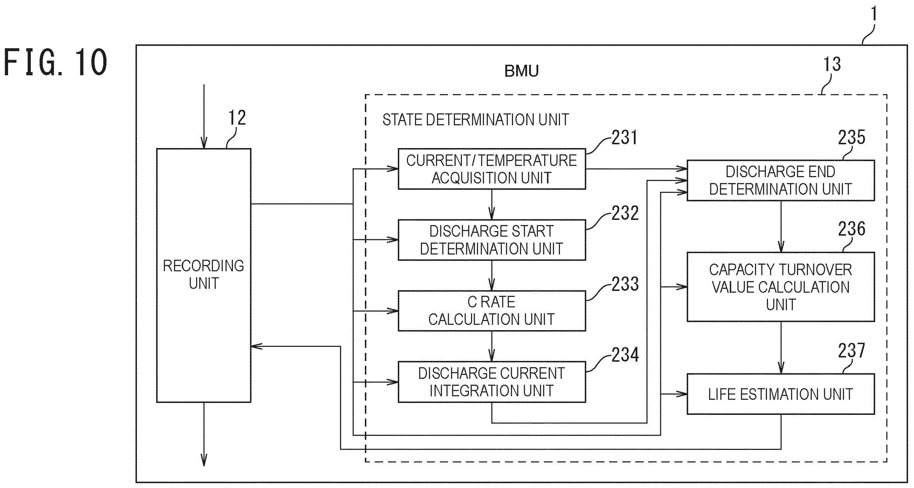

Next, the lead-acid battery system and a lead-acid battery life estimation method according to the second embodiment of the present invention will be described with reference to FIGS. 10 to 14. a block diagram illustrating internal configurations of a recording unit 12 and a state determination unit 13 included in a BMU 1 illustrated in FIG. 2 in the lead-acid battery system S according to the second embodiment of the present invention illustrated in FIG. 1.

The lead-acid battery system S according to the second embodiment has the same basic configuration as the lead-acid battery system S according to the first embodiment, and is different from the lead-acid battery system S according to the first embodiment in a configuration of the state determination unit 13.

Similarly to the state determination unit 13 in the lead-acid battery system S according to the first embodiment, the state determination unit 13 in the lead-acid battery system S according to the second embodiment determines a state of a lead-acid battery B, specifically, estimates a remaining life of the lead-acid battery B by comparing a capacity turnover value from the beginning to the end of life and a capacity turnover value during operation. However, the state determination unit 13 in the lead-acid battery system S according to the second embodiment is different from the state determination unit 13 in the lead-acid battery system S according to the first embodiment in that, unlike the first embodiment in which the temperature correction is performed at the time of current value integration when the lead-acid battery B is discharged in view of the fact that the life of the lead-acid battery B changes depending on the temperature of the lead-acid battery B, the capacity turnover value is calculated using a temperature correction coefficient Kt at the time of calculating the capacity turnover value during operation.

As illustrated in FIG. 10, the state determination unit 13 in the lead-acid battery system S according to the second embodiment includes a current/temperature acquisition unit 231, a discharge start determination unit 232, a C rate calculation unit 233, a discharge current integration unit 234, a discharge end determination unit 235, a capacity turnover value calculation unit 236, and a life estimation unit 237.

The current/temperature acquisition unit 231 acquires information regarding a current value and a temperature of the lead-acid battery B input to the recording unit 12 via a measurement unit 11 from the recording unit 12 from the start to the end of processing in the state determination unit 13.

In addition, the discharge start determination unit 232 determines whether or not the discharge of the lead-acid battery B has started based on the current value of the lead-acid battery B acquired by the current/temperature acquisition unit 231. Specifically, it is determined that the discharge has started in a case where the current value of the lead-acid battery B acquired by the current/temperature acquisition unit 231 is smaller than a threshold, and it is determined that the lead-acid battery B is in a charge state in a case where the current value is equal to or larger than the threshold. The threshold is specifically 0 amperes, and it is determined that the discharge has started in a case where the current value of the lead-acid battery B is a negative current, and it is determined that the lead-acid battery B is in the charge state in a case where the current value of the lead-acid battery B is 0 or a positive current. The threshold for the discharge start determination is set by a setting unit 14 and recorded in the recording unit 12, and the discharge start determination unit 232 acquires information regarding the threshold from the recording unit 12.

After the discharge start determination unit 232 determines that the discharge of the lead-acid battery B has started, the C rate calculation unit 233 calculates a C rate from the current value of the lead-acid battery B acquired by the current/temperature acquisition unit 231.

The C rate represents a magnitude of a discharge current and is calculated by dividing the current value of the lead-acid battery B acquired by the current/temperature acquisition unit 231 by a rated current of the lead-acid battery B. Information regarding the rated current of the lead-acid battery B is recorded in the recording unit 12, and the C rate calculation unit 233 acquires the information regarding the rated current from the recording unit 12.

In addition, the discharge current integration unit 234 integrates the current values acquired by the current/temperature acquisition unit 231 after the start of the discharge of the lead-acid battery B, and calculates an integrated discharge capacity value after the start of the discharge of the lead-acid battery B.

In addition, the discharge end determination unit 235 determines whether or not the discharge of the lead-acid battery B has ended based on the current value of the lead-acid battery B acquired by the current/temperature acquisition unit 231. Specifically, in a case where the current value of the lead-acid battery B acquired by the current/temperature acquisition unit 231 is equal to or larger than a threshold, it is determined that the lead-acid battery B is in the charge state and the discharge has ended, and in a case where the current value is smaller than the threshold, it is determined that the lead-acid battery B is in a discharge state. The threshold is the same as the threshold used by discharge start determination unit 232.

Next, in a case where it is determined by the discharge end determination unit 235 that the discharge of the lead-acid battery B has ended, the capacity turnover value calculation unit 236 calculates the capacity turnover value during operation (hereinafter, referred to as a CT value during operation).

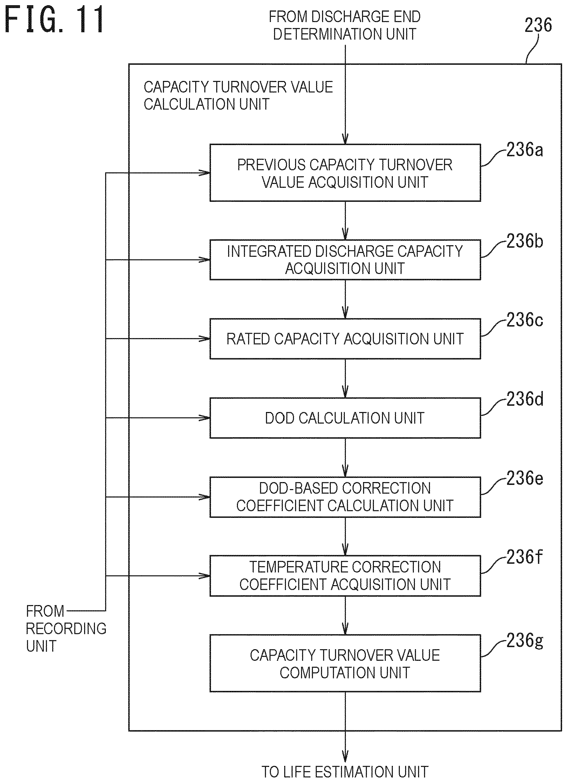

An internal configuration of the capacity turnover value calculation unit 236 will be described in more detail below. FIG. 11 is a block diagram illustrating an internal configuration of the capacity turnover value calculation unit 236 included in the state determination unit 13 illustrated in FIG. 10.

The capacity turnover value calculation unit 236 includes a previous capacity turnover value acquisition unit 236a, an integrated discharge capacity acquisition unit 236b, a rated capacity acquisition unit 236c, a DOD calculation unit 236d, a DOD-based correction coefficient calculation unit 236e, a temperature correction coefficient acquisition unit 236f, and a capacity turnover value computation unit 236g.

In a case where it is determined by the discharge end determination unit 235 that the discharge of the lead-acid battery B has ended, the previous capacity turnover value acquisition unit 236a acquires a capacity turnover value before the start of the processing in the state determination unit 13 (before a start timing a of the processing in the state determination unit 13 in the example illustrated in FIG. 8) (hereinafter, referred to as a previous CT value) from the recording unit 12. The previous CT value is a CT value during operation calculated by the capacity turnover value calculation unit 236 at the time of the previous processing in the state determination unit 13, and already input from the capacity turnover value calculation unit 236 to the recording unit 12.

In addition, the integrated discharge capacity acquisition unit 236b acquires information regarding the integrated discharge capacity value from the start of the discharge of the lead-acid battery B calculated by the discharge current integration unit 234.

Further, the rated capacity acquisition unit 236c acquires information regarding the rated capacity (Ah) of the lead-acid battery B from the recording unit 12.

In addition, the DOD calculation unit 236d calculates the DOD from the integrated discharge capacity after the start of the discharge of the lead-acid battery B acquired by the integrated discharge capacity acquisition unit 236b and the rated capacity of the lead-acid battery B acquired by the rated capacity acquisition unit 236c based on the following formula: DOD = integrated discharge capacity/rated capacity $\times$ 100%. The DOD represents the depth of discharge calculated by dividing the integrated discharge capacity after the start of the discharge of the lead-acid battery B by the rated capacity of the lead-acid battery B.

The DOD-based correction coefficient calculation unit 236e calculates a DOD-based correction coefficient Kdod(c) based on the DOD calculated by the DOD calculation unit 236d.

The DOD-based correction coefficient Kdod(c) is calculated by Formula (2) described above using the DOD calculated by the DOD calculation unit 236d and an average C rate obtained by averaging the C rates calculated by the C rate calculation unit 233 with a discharge time.

In addition, the temperature correction coefficient acquisition unit 236f acquires the temperature correction coefficient Kt corresponding to the temperature of the lead-acid battery B acquired by the current/temperature acquisition unit 231 from the recording unit 12 that records a temperature coefficient conversion table representing a relationship between the temperature of the lead-acid battery B and the temperature correction coefficient.

Further, the capacity turnover value computation unit 236g calculates the CT value during operation by the following Formula (4) using the previous CT value acquired by the previous capacity turnover value acquisition unit 236a, the integrated discharge capacity after the start of the discharge of the lead-acid battery B acquired by the integrated discharge capacity acquisition unit 236b, the rated capacity (Ah) acquired by the rated capacity acquisition unit 236c, the DOD-based correction coefficient Kdod(c) calculated by the DOD-based correction coefficient calculation unit 236e, and the temperature correction coefficient Kt acquired by the temperature correction coefficient acquisition unit 236f.

[Mathematical Formula 4]

$$\text{CT value during operation} = \text{Previous CT value} + \frac{\text{Integrated discharge capacity}}{\text{Rated capacity (Ah)}} \times K_t \times K_{dod}(c) \quad \cdots \quad (4)$$

Then, the life estimation unit 237 of the state determination unit 13 estimates the remaining life of the lead-acid battery B by comparing the CT value from the beginning to the end of life acquired from the recording unit 12 with the CT value during operation calculated by the capacity turnover value calculation unit 236. That is, the life estimation unit 237 estimates the remaining life of the lead-acid battery B from a CT value obtained by subtracting the CT value during operation from the CT value from the beginning to the end of life.

Then, the life estimation unit 237 records an estimation result of the life estimation unit 237 including the CT value during operation in the recording unit 12.

As described above, in the lead-acid battery system S according to the second embodiment, the capacity turnover value calculation unit 236 calculates the capacity turnover value during operation by using the DOD-based correction coefficient Kdod(c) calculated based on the DOD representing the depth of discharge calculated by dividing the integrated discharge capacity after the start of the discharge of the lead-acid battery B by the rated capacity of the lead-acid battery B. As a result, it is possible to calculate the capacity turnover value during operation in consideration of the magnitude of the DOD, to consider the progress of deterioration due to softening or sulfation of an active material in addition to corrosion of a positive electrode foil, and to accurately estimate the remaining life of the lead-acid battery B.

In addition, in the lead-acid battery system S according to the second embodiment, the capacity turnover value calculation unit 236 calculates the DOD-based correction coefficient Kdod(c) by using the above-described DOD and the average C rate obtained by averaging, with the discharge time, the C rates each representing the magnitude of the discharge current calculated by dividing a discharge current value when the lead-acid battery B is discharged by the rated capacity of the lead-acid battery B. As illustrated in FIG. 17, since the DOD varies depending on the C rate representing the magnitude of the discharge current, as the DOD-based correction coefficient Kdod(c) is calculated using the DOD and the average C rate, the accuracy of the capacity turnover value during operation increases, and the remaining life of the lead-acid battery B can be more accurately estimated.

In the lead-acid battery system S according to the second embodiment, in a case where the lead-acid battery B is a bipolar lead-acid battery, it is possible to provide the lead-acid battery system S capable of accurately estimating the remaining life of the bipolar lead-acid battery.

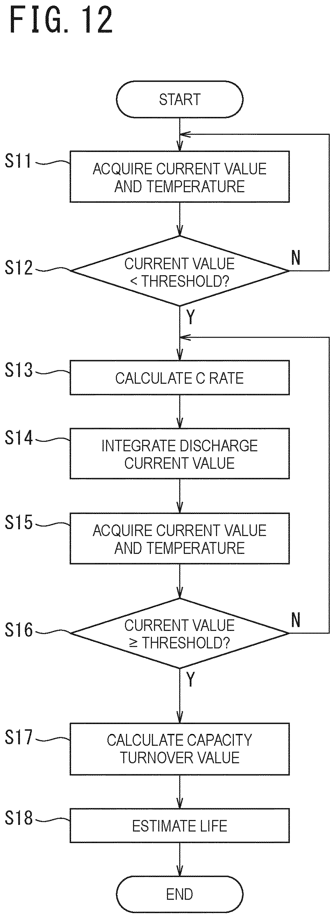

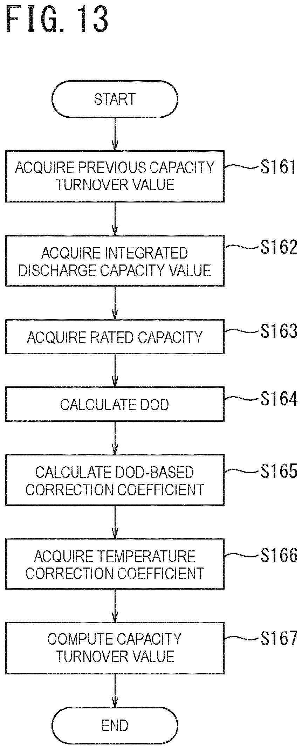

Next, the lead-acid battery life estimation method according to the second embodiment will be described with reference to a flowchart illustrating a flow of processing in the state determination unit illustrated in FIG. 12, a flowchart illustrating a flow of processing of step S17 (capacity turnover value calculation step) in the flowchart of FIG. 12 illustrated in FIG. 13, and a flowchart illustrating a flow of processing of step S165 (DOD-based correction coefficient calculation step) in the flowchart of FIG. 13 illustrated in FIG. 14.

For example, the state determination unit 13 starts the processing from the start timing a in FIG. 8, and as illustrated in FIG. 12, first, in step S11, the current/temperature acquisition unit 231 of the state determination unit 13 acquires, from the recording unit 12, information regarding the current value and the temperature of the lead-acid battery B input to the recording unit 12 via the measurement unit 11 from the start to the end of the processing in the state determination unit 13 (current value/temperature acquisition step).

Next, in step S12, the discharge start determination unit 232 of the state determination unit 13 determines whether or not the discharge of the lead-acid battery B has started based on the current value of the lead-acid battery B acquired in step S11 (discharge start determination step). Specifically, in a case where the current value of the lead-acid battery B acquired in step S11 is smaller than the threshold, it is determined that the discharge has started, and in a case where the current value is equal to or larger than the threshold, it is determined that the lead-acid battery B is in the charge state. The threshold is specifically 0 amperes, and it is determined that the discharge has started in a case where the current value of the lead-acid battery B is a negative current, and it is determined that the lead-acid battery B is in the charge state in a case where the current value of the lead-acid battery B is 0 or a positive current. The threshold for the discharge start determination is set by the setting unit 14 and recorded in the recording unit 12, and the discharge start determination unit 132 acquires information regarding the threshold from the recording unit 12.

In a case where the determination result in step S12 is YES (in a case where it is determined that the discharge has started), the processing proceeds to step S13, and in a case where the determination result is NO, the processing returns to step S11.

In step S13, the C rate calculation unit 233 of the state determination unit 13 calculates the C rate from the current value of the lead-acid battery B acquired in step S11 (C rate calculation step).

As described above, the C rate represents the magnitude of the discharge current, and is calculated by dividing the current value of the lead-acid battery B acquired in step S11 by the rated current of the lead-acid battery B. Information regarding the rated current of the lead-acid battery B is recorded in the recording unit 12, and the C rate calculation unit 133 acquires the information regarding the rated current from the recording unit 12.

Next, in step S14, the discharge current integration unit 234 of the state determination unit 13 integrates the current values acquired in step S11 after the start of the discharge of the lead-acid battery B, and calculates the integrated discharge capacity value after the start of the discharge of the lead-acid battery B (integrated discharge capacity calculation step).

Next, in step S15, the current/temperature acquisition unit 231 of the state determination unit 13 of the state determination unit 13 again acquires the information regarding the current value and the temperature of the lead-acid battery B input to the recording unit 12 via the measurement unit 11 from the recording unit 12 (current value/temperature acquisition step).

Next, in step S16, the discharge end determination unit 235 of the state determination unit 13 determines whether or not the discharge of the lead-acid battery B has ended based on the current value of the lead-acid battery B acquired in step S15 (discharge end determination step). Specifically, in a case where the current value of the lead-acid battery B acquired in step S15 is equal to or larger than the threshold, it is determined that the lead-acid battery B is in the charge state and the discharge has ended, and in a case where the current value is smaller than the threshold, it is determined that the lead-acid battery B is in the discharge state. The threshold is the same as the threshold used in step S12.

In a case where the determination result in step S16 is YES (in a case where it is determined that the discharge has ended), the processing proceeds to step S17, and in a case where the determination result is NO, the processing returns to step S13.

In step S17, the capacity turnover value calculation unit 236 of the state determination unit 13 calculates the capacity turnover value during operation (hereinafter, referred to as the CT value during operation) (capacity turnover value calculation step).

A detailed flow of the processing of step S17 will be described with reference to FIG. 13.

First, in step S161, the previous capacity turnover value acquisition unit 236a of the capacity turnover value calculation unit 236 acquires the capacity turnover value before the start of the processing in the state determination unit 13 (before the start timing a of the processing in the state determination unit 13 in the example illustrated in FIG. 8) (hereinafter, referred to as the previous CT value) from the recording unit 12 (previous capacity turnover value acquisition step). The previous CT value is a CT value during operation calculated by the capacity turnover value calculation unit 236 at the time of the previous processing in the state determination unit 13, and already input from the capacity turnover value calculation unit 236 to the recording unit 12.

Next, in step S162, the integrated discharge capacity acquisition unit 236b of the capacity turnover value calculation unit 236 acquires information regarding the integrated discharge capacity value after the start of the discharge of the lead-acid battery B calculated in step S5 (integrated discharge capacity value acquisition step).

Next, in step S163, the rated capacity acquisition unit 236c of the capacity turnover value calculation unit 236 acquires information regarding the rated capacity of the lead-acid battery B from the recording unit 12.

Next, in step S164, the DOD calculation unit 236d of the capacity turnover value calculation unit 236 calculates the DOD from the integrated discharge capacity after the start of the discharge of the lead-acid battery B acquired in step S162 and the rated capacity of the lead-acid battery B acquired in step S163 based on the following formula: DOD = integrated discharge capacity/rated capacity × 100% (DOD calculation step). The DOD represents the depth of discharge calculated by dividing the integrated discharge capacity after the start of the discharge of the lead-acid battery B by the rated capacity of the lead-acid battery B.

Next, in step S165, the DOD-based correction coefficient calculation unit 236e of the capacity turnover value calculation unit 236 calculates the DOD-based correction coefficient Kdod(c) based on the DOD calculated by the DOD calculation unit 236d (DOD-based correction coefficient calculation step).

A detailed flow of the processing of step S165 will be described with reference to FIG. 14.

First, in step S1651, the DOD-based correction coefficient calculation unit 236e acquires the DOD calculated in step S164 from the DOD calculation unit 236d (DOD acquisition step).

Next, in step S1652, the DOD-based correction coefficient calculation unit 236e calculates the average C rate obtained by averaging the C rates calculated in step S13 with the discharge time (average C rate calculation step).

Next, in step S1653, the DOD-based correction coefficient calculation unit 236e calculates the DOD-based correction coefficient Kdod(c) by using the DOD acquired in step S1651 and the average C rate calculated in step S1652 according to Formula (2) described above.

When the calculation of the DOD-based correction coefficient Kdod(c) is completed, in step S166, the temperature correction coefficient acquisition unit 236f acquires the temperature correction coefficient Kt corresponding to the temperature of the lead-acid battery B acquired in step S11 from the recording unit 12 that records the temperature coefficient conversion table representing the relationship between the temperature of the lead-acid battery B and the temperature correction coefficient.

Next, in step S167, the capacity turnover value computation unit 236g calculates the CT value during operation by Formula (4) described above using the previous CT value acquired in step S161, the integrated discharge capacity after the start of the discharge of the lead-acid battery B acquired in step S162, the rated capacity (Ah) acquired in step S163, the DOD-based correction coefficient Kdod(c) calculated in step S165, and the temperature correction coefficient Kt acquired in step S166.

Accordingly, the processing of step S17 ends.

In step S18, the life estimation unit 237 of the state determination unit 13 estimates the remaining life of the lead-acid battery B by comparing the CT value from the beginning to the end of life acquired from the recording unit 12 with the CT value during operation calculated in step S16. That is, the life estimation unit 138 estimates the remaining life of the lead-acid battery B from a CT value obtained by subtracting the CT value during operation from the CT value from the beginning to the end of life.

Then, the life estimation unit 237 records an estimation result of the life estimation unit 237 including the CT value during operation in the recording unit 12.

Accordingly, the processing in the state determination unit 13 ends.

As described above, in the lead-acid battery life estimation method according to the second embodiment, in the capacity turnover value calculation step (step S17), the capacity turnover value during operation is calculated using the DOD-based correction coefficient Kdod(c) calculated based on the DOD representing the depth of discharge calculated by dividing the integrated discharge capacity after the start of the discharge of the lead-acid battery B by the rated capacity of the lead-acid battery B. As a result, it is possible to calculate the capacity turnover value during operation in consideration of the magnitude of the DOD, to consider the progress of deterioration due to softening or sulfation of the active material in addition to corrosion of the positive electrode foil, and to provide the lead-acid battery life estimation method capable of accurately estimating the remaining life of the lead-acid battery B.

In the lead-acid battery life estimation method according to the second embodiment, in the capacity turnover value calculation step (step S17), the DOD-based correction coefficient Kdod(c) is calculated using the DOD and the average C rate obtained by averaging, with the discharge time, the C rates each representing the magnitude of the discharge current calculated by dividing the discharge current value when the lead-acid battery B is discharged by the rated capacity of the lead-acid battery. Since the DOD varies depending on the C rate representing the magnitude of the discharge current, as the DOD-based correction coefficient Kdod(c) is calculated using the DOD and the average C rate, the accuracy of the capacity turnover value during operation increases, and it is possible to provide the lead-acid battery life estimation method capable of more accurately estimating the remaining life of the lead-acid battery B.

In the lead-acid battery life estimation method according to the second embodiment, in a case where the lead-acid battery B is a bipolar lead-acid battery, it is possible to provide a lead-acid battery life estimation method capable of accurately estimating the remaining life of the bipolar lead-acid battery.

Although the embodiments of the present invention have been described above, the present invention is not limited thereto, and various modifications and improvements can be made therein.

For example, in the lead-acid battery system S and the lead-acid battery life estimation method according to the first embodiment, the current value temperature correction unit 134 (step S4) corrects the current value of the lead-acid battery B acquired by the current/temperature acquisition unit 131 (step S1) according to the temperature, but the temperature correction does not have to be necessarily performed.

In the lead-acid battery system S and the lead-acid battery life estimation method according to the second embodiment, the temperature correction coefficient acquisition unit 236f (step S166) acquires the temperature correction coefficient Kt corresponding to the temperature of the lead-acid battery B acquired by the current/temperature acquisition unit 231 (step S11) from the recording unit 12, and the capacity turnover value computation unit 236g (step S167) calculates the CT value during operation by using the temperature correction coefficient Kt, but the correction using the temperature correction coefficient Kt does not have to be necessarily performed.

In the lead-acid battery system S and the lead-acid battery life estimation method according to the first embodiment, and the lead-acid battery system S and the lead-acid battery life estimation method according to the second embodiment, the DOD-based correction coefficient Kdod(c) is calculated by Formula (2), but the DOD-based correction coefficient Kdod(c) does not have to be calculated necessarily based on Formula (2) as long as the DOD-based correction coefficient Kdod(c) is calculated using the DOD and the average C rate.

Industrial Applicability

The lead-acid battery system and the lead-acid battery life estimation method according to the present invention can accurately estimate a remaining life of a lead-acid battery by calculating a capacity turnover value during operation in consideration of a magnitude of a DOD, and thus can be extremely advantageously used in various industries.

Reference Signs List

1 BMU
2 EMS
3 PCS
11 Measurement unit
12 Recording unit
13 State determination unit
14 Setting unit
15 Communication unit
131 Current/temperature acquisition unit
132 Discharge start determination unit
133 C rate calculation unit
134 Current value temperature correction unit
135 Discharge current integration unit
136 Discharge end determination unit
137 Capacity turnover value calculation unit
137a Previous capacity turnover value acquisition unit
137b Integrated discharge capacity acquisition unit
137c Rated capacity acquisition unit
137d DOD calculation unit
137e DOD-based correction coefficient calculation unit
137f Capacity turnover value computation unit
138 Life estimation unit
231 Current/temperature acquisition unit
232 Discharge start determination unit
233 C rate calculation unit
234 Discharge current integration unit
235 Discharge end determination unit
236 Capacity turnover value calculation unit
236a Previous capacity turnover value acquisition unit
236b Integrated discharge capacity acquisition unit
236c Rated capacity acquisition unit
236d DOD calculation unit
236e DOD-based correction coefficient calculation unit
236f Temperature correction coefficient acquisition unit
236g Capacity turnover value computation unit
237 Life estimation unit
B Lead-acid battery
S Lead-acid battery system

**Claims**

1. A lead-acid battery system configured to estimate a remaining life of a lead-acid battery by comparing a capacity turnover value from a beginning to an end of life with a capacity turnover value during operation, the lead-acid battery system comprising:

a capacity turnover value calculation unit configured to calculate the capacity turnover value during operation,

wherein the capacity turnover value calculation unit calculates the capacity turnover value during operation by using a depth-of-discharge (DOD)-based correction coefficient calculated based on a DOD representing a depth of discharge calculated by dividing an integrated discharge capacity after a start of a discharge of the lead-acid battery by a rated capacity of the lead-acid battery.

2. The lead-acid battery system according to claim 1, wherein the capacity turnover value calculation unit calculates the DOD-based correction coefficient by using the DOD and an average C rate obtained by averaging, with a discharge time, C rates each representing a magnitude of a discharge current calculated by dividing a discharge current value when the lead-acid battery is discharged by the rated capacity of the lead-acid battery.

3. The lead-acid battery system according to claim 1 or 2, wherein the lead-acid battery is a bipolar lead-acid battery.

4. A lead-acid battery life estimation method in which a remaining life of a lead-acid battery is estimated by comparing a capacity turnover value from a beginning to an end of life with a capacity turnover value during operation, the lead-acid battery life estimation method comprising:

a capacity turnover value calculation step of calculating the capacity turnover value during operation, wherein in the capacity turnover value calculation step, the capacity turnover value during operation is calculated using a depth-of-discharge (DOD)-based correction coefficient calculated based on a DOD representing a depth of discharge calculated by dividing an integrated discharge capacity after a start of a discharge of the lead-acid battery by a rated capacity of the lead-acid battery.

5. The lead-acid battery life estimation method according to claim 4, wherein in the capacity turnover value calculation step, the DOD-based correction coefficient is calculated using the DOD and an average C rate obtained by averaging, with a discharge time, C rates each representing a magnitude of a discharge current calculated by dividing a discharge current value when the lead-acid battery is discharged by the rated capacity of the lead-acid battery.

6. The lead-acid battery life estimation method according to claim 4 or 5, wherein the lead-acid battery is a bipolar lead-acid battery.

# FIG. 1

# FIG. 2

FIG. 3

BMU

13

STATE DETERMINATION UNIT

CURRENT / TEMPERATURE ACQUISITION UNIT — 131

DISCHARGE START DETERMINATION UNIT — 132

C RATE CALCULATION UNIT — 133

CURRENT VALUE TEMPERATURE CORRECTION UNIT — 134

DISCHARGE CURRENT INTEGRATION UNIT — 135

DISCHARGE END DETERMINATION UNIT — 136

CAPACITY TURNOVER VALUE CALCULATION UNIT — 137

LIFE ESTIMATION UNIT — 138

RECORDING UNIT — 12

1

EP 4 474 839 A1

# FIG. 4

FROM DISCHARGE END
DETERMINATION UNIT

137

CAPACITY TURNOVER VALUE
CALCULATION UNIT

PREVIOUS CAPACITY TURNOVER
VALUE ACQUISITION UNIT — 137a

INTEGRATED DISCHARGE CAPACITY
ACQUISITION UNIT — 137b

RATED CAPACITY ACQUISITION UNIT — 137c

DOD CALCULATION UNIT — 137d

DOD-BASED CORRECTION
COEFFICIENT CALCULATION UNIT — 137e

FROM
RECORDING
UNIT

CAPACITY TURNOVER VALUE
COMPUTATION UNIT — 137f

TO LIFE ESTIMATION UNIT

# FIG. 5

```
                    ┌──────────────┐
                    │    START     │
                    └──────┬───────┘
                           │◄──────────────────┐
          ┌────────────────▼────────────────┐  │
    S1 ───│    ACQUIRE CURRENT VALUE         │  │
          │       AND TEMPERATURE            │  │
          └────────────────┬────────────────┘  │
                           │                    │
                        ╱──▼──╲          N       │
    S2 ──────────────◄ CURRENT VALUE ├──────────┘
                     ╲ < THRESHOLD? ╱
                        ╲─────╱
                           │ Y
                           │◄──────────────────────┐
          ┌────────────────▼────────────────┐      │
    S3 ───│        CALCULATE C RATE          │      │
          └────────────────┬────────────────┘      │
          ┌────────────────▼────────────────┐      │
    S4 ───│    CORRECT CURRENT VALUE         │      │
          │   ACCORDING TO TEMPERATURE       │      │
          └────────────────┬────────────────┘      │
          ┌────────────────▼────────────────┐      │
    S5 ───│    INTEGRATE DISCHARGE           │      │
          │       CURRENT VALUES             │      │
          └────────────────┬────────────────┘      │
          ┌────────────────▼────────────────┐      │
    S6 ───│    ACQUIRE CURRENT VALUE         │      │
          │       AND TEMPERATURE            │      │
          └────────────────┬────────────────┘      │
                        ╱──▼──╲          N           │
    S7 ──────────────◄ CURRENT VALUE ├──────────────┘
                     ╲ ≥ THRESHOLD? ╱
                        ╲─────╱
                           │ Y
          ┌────────────────▼────────────────┐
    S8 ───│    CALCULATE CAPACITY            │
          │       TURNOVER VALUE             │
          └────────────────┬────────────────┘
          ┌────────────────▼────────────────┐
    S9 ───│        ESTIMATE LIFE             │
          └────────────────┬────────────────┘
                    ┌──────▼───────┐
                    │     END      │
                    └──────────────┘
```

# FIG. 6

```
          ┌─────────────┐
          │    START    │
          └─────────────┘
                 │
                 ▼
    ┌──────────────────────────┐
    │  ACQUIRE PREVIOUS CAPACITY │──── S71
    │      TURNOVER VALUE        │
    └──────────────────────────┘
                 │
                 ▼
    ┌──────────────────────────┐
    │    ACQUIRE INTEGRATED     │──── S72
    │  DISCHARGE CAPACITY VALUE  │
    └──────────────────────────┘
                 │
                 ▼
    ┌──────────────────────────┐
    │   ACQUIRE RATED CAPACITY  │──── S73
    └──────────────────────────┘
                 │
                 ▼
    ┌──────────────────────────┐
    │      CALCULATE DOD        │──── S74
    └──────────────────────────┘
                 │
                 ▼
    ┌──────────────────────────┐
    │    CALCULATE DOD-BASED    │──── S75
    │   CORRECTION COEFFICIENT   │
    └──────────────────────────┘
                 │
                 ▼
    ┌──────────────────────────┐
    │     COMPUTE CAPACITY      │──── S76
    │      TURNOVER VALUE        │
    └──────────────────────────┘
                 │
                 ▼
          ┌─────────────┐
          │     END     │
          └─────────────┘
```

## FIG. 7

```
        ┌─────────────┐
        │    START    │
        └─────────────┘
               │
               ▼
    ┌───────────────────────┐
    │     ACQUIRE DOD       │────S751
    └───────────────────────┘
               │
               ▼
    ┌───────────────────────┐
    │ CALCULATE AVERAGE C RATE │────S752
    └───────────────────────┘
               │
               ▼
    ┌───────────────────────┐
    │  CALCULATE DOD-BASED   │
    │  CORRECTION COEFFICIENT BY │────S753
    │ USING DOD AND AVERAGE C RATE │
    └───────────────────────┘
               │
               ▼
        ┌─────────────┐
        │     END     │
        └─────────────┘
```

## FIG. 8

FIG. 9

FIG. 10

EP 4 474 839 A1

# FIG. 11

FROM DISCHARGE END
DETERMINATION UNIT

236

CAPACITY TURNOVER VALUE
CALCULATION UNIT

PREVIOUS CAPACITY TURNOVER
VALUE ACQUISITION UNIT — 236a

INTEGRATED DISCHARGE CAPACITY
ACQUISITION UNIT — 236b

RATED CAPACITY ACQUISITION UNIT — 236c

DOD CALCULATION UNIT — 236d

DOD-BASED CORRECTION
COEFFICIENT CALCULATION UNIT — 236e

TEMPERATURE CORRECTION
COEFFICIENT ACQUISITION UNIT — 236f

FROM
RECORDING
UNIT

CAPACITY TURNOVER VALUE
COMPUTATION UNIT — 236g

TO LIFE ESTIMATION UNIT

# FIG. 12

```
            ┌─────────────┐
            │    START    │
            └─────────────┘
                   │
                   ▼  ◄──────────────────┐
        ┌──────────────────────┐         │
  S11   │ ACQUIRE CURRENT VALUE │         │
        │   AND TEMPERATURE     │         │
        └──────────────────────┘         │
                   │                      │
                   ▼                      │
          ╱─────────────────╲    N        │
  S12    ╱   CURRENT VALUE    ╲───────────┘
         ╲   < THRESHOLD?     ╱
          ╲─────────────────╱
                   │ Y
                   ▼  ◄──────────────────┐
        ┌──────────────────────┐         │
  S13   │   CALCULATE C RATE    │         │
        └──────────────────────┘         │
                   │                      │
                   ▼                      │
        ┌──────────────────────┐         │
  S14   │  INTEGRATE DISCHARGE  │         │
        │    CURRENT VALUE      │         │
        └──────────────────────┘         │
                   │                      │
                   ▼                      │
        ┌──────────────────────┐         │
  S15   │ ACQUIRE CURRENT VALUE │         │
        │   AND TEMPERATURE     │         │
        └──────────────────────┘         │
                   │                      │
                   ▼                      │
          ╱─────────────────╲    N        │
  S16    ╱   CURRENT VALUE    ╲───────────┘
         ╲   ≥ THRESHOLD?     ╱
          ╲─────────────────╱
                   │ Y
                   ▼
        ┌──────────────────────┐
  S17   │ CALCULATE CAPACITY    │
        │   TURNOVER VALUE      │
        └──────────────────────┘
                   │
                   ▼
        ┌──────────────────────┐
  S18   │     ESTIMATE LIFE     │
        └──────────────────────┘
                   │
                   ▼
            ┌─────────────┐
            │     END     │
            └─────────────┘
```

# FIG. 13

```
                    START

         ACQUIRE PREVIOUS CAPACITY      S161
              TURNOVER VALUE

            ACQUIRE INTEGRATED          S162
         DISCHARGE CAPACITY VALUE

           ACQUIRE RATED CAPACITY       S163

              CALCULATE DOD             S164

           CALCULATE DOD-BASED          S165
          CORRECTION COEFFICIENT

          ACQUIRE TEMPERATURE           S166
          CORRECTION COEFFICIENT

            COMPUTE CAPACITY            S167
              TURNOVER VALUE

                     END
```

# FIG. 14

```
        ( START )
            │
            ▼
┌─────────────────────────┐
│     ACQUIRE DOD         │──── S1651
└─────────────────────────┘
            │
            ▼
┌─────────────────────────┐
│  CALCULATE AVERAGE C RATE │──── S1652
└─────────────────────────┘
            │
            ▼
┌─────────────────────────────┐
│ CALCULATE DOD-BASED CORRECTION │──── S1653
│  COEFFICIENT BY USING DOD AND  │
│      AVERAGE C RATE            │
└─────────────────────────────┘
            │
            ▼
        ( END )
```

# FIG. 15

TEST PERIOD : 4.5 YEARS

TEST CONDITIONS
TEMPERATURE : 25°C
DISCHARGE : 0.23×2.3hn
CHARGE : 2.45V,104%

TEST RESULT

DISCHARGE VOLTAGE [V]

2.0

DEADLINE

SPECIFICATION : 4200 CYCLES    4500 CYCLES

0        1000      2000      3000      4000      5000

NUMBER OF CYCLES

# FIG. 16

AMBIENT TEMPERATURE : 25℃

A

LIFE [CYCLE] vs DOD[%]

# FIG. 17

DOD[%] vs C RATE [$C_{10}$A]

## INTERNATIONAL SEARCH REPORT

| International application No. |
|---|
| **PCT/JP2023/002257** |

| | |
|---|---|
| **A.** | **CLASSIFICATION OF SUBJECT MATTER** |

***G01R 31/392***(2019.01)i; ***G01R 31/379***(2019.01)i; ***G01R 31/3828***(2019.01)i; ***H01M 10/48***(2006.01)i; ***H02J 7/00***(2006.01)i
FI:   G01R31/392; G01R31/379; G01R31/3828; H01M10/48 P; H02J7/00 Y

According to International Patent Classification (IPC) or to both national classification and IPC

| | |
|---|---|
| **B.** | **FIELDS SEARCHED** |

Minimum documentation searched (classification system followed by classification symbols)

G01R31/392; G01R31/379; G01R31/3828; H01M10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| A | JP 2003-161768 A (NTT POWER & BUILDING FACILITIES INC) 06 June 2003 (2003-06-06) | 1-6 |
| A | JP 2008-74257 A (MAZDA MOTOR CORP) 03 April 2008 (2008-04-03) | 1-6 |
| A | JP 6430054 B1 (FURUKAWA BATTERY CO LTD) 28 November 2018 (2018-11-28) | 1-6 |
| A | WO 2010/001605 A1 (PANASONIC CORPORATION) 07 January 2010 (2010-01-07) | 1-6 |
| A | JP 2017-219405 A (HITACHI CHEMICAL CO LTD) 14 December 2017 (2017-12-14) | 1-6 |
| A | JP 2018-152959 A (OMRON TATEISI ELECTRONICS CO) 27 September 2018 (2018-09-27) | 1-6 |
| A | WO 2011/051997 A1 (SHIN-KOBE ELECTRIC MACHINERY CO., LTD.) 05 May 2011 (2011-05-05) | 1-6 |
| A | WO 2020/066290 A1 (FURUKAWA BATTERY CO LTD) 02 April 2020 (2020-04-02) | 1-6 |
| A | JP 2001-91605 A (YUASA CORP) 06 April 2001 (2001-04-06) | 1-6 |

| | |
|---|---|
| ✓ Further documents are listed in the continuation of Box C. | ✓ See patent family annex. |

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **17 March 2023** | **04 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
| --- |
| **PCT/JP2023/002257** |

## C.    DOCUMENTS CONSIDERED TO BE RELEVANT

| Category* | Citation of document, with indication, where appropriate, of the relevant passages | Relevant to claim No. |
| --- | --- | --- |
| A | CN 103529399 A (HUNAN UNIVERSITY) 22 January 2014 (2014-01-22) | 1-6 |
| A | CN 112290637 A (ELECTRIC POWER RESEARCH INSTITUTE OF STATE GRID LIAONING ELECTRIC POWER SUPPLY CO., LTD.) 29 January 2021 (2021-01-29) | 1-6 |
| A | 中村秀人；可知純夫；渡部大介；久保山浩稔；有馬康弘；三浦優, 蓄電池状態監視装置（ＢＭＵ）の開発, 古河電工時報, February 2013, no. 131, pp. 16-20, available at Internet<URL: https://www.furukawa.co.jp/jiho/fj131/fj131_03.pdf>, section "3.2 BMU (Battery Monitoring Unit)", (NAKAMURA, Hideto. KACHI, Sumio. WATANABE, Daisuke. KUBOYAMA, Hirotoshi. ARIMA, Yasuhiro. MIURA, Masaru. Development of the Battery Monitoring Unit (BMU). The Furukawa Elertric review.) | 1-6 |
| A | 中島秀仁；本間徳則；緑川淳；赤阪有一；柴田智史；吉田英明；橋本健介；荻野由涼；手塚渉；三浦優；古川淳；LAM, L. T.；菅田純雄, ウルトラバッテリーの開発, 古河電工時報, February 2013, no. 131, pp. 21-27, available at Internet<URL: https://www.furukawa.co.jp/jiho/fj131/fj131_04.pdf> section "2.2.2 Test results", fig. 4, (NAKAJIMA, Hidehito. HONMA, Tokunori. MIDORIKAWA, Kiyoshi. AKASAKA, Yuichi. SHIBATA, Satoshi. YOSHIDA, Hideaki. HASHIMOTO, Kensuke. OGINO, Yusuke. TEZUKA, Wataru. MIURA, Masaru. FURUKAWA, Jun. LAM, L. T. SUGATA, Sumio. Development of UltraBattery. The Furukawa Elertric review.) | 1-6 |

Form PCT/ISA/210 (second sheet) (January 2015)

**INTERNATIONAL SEARCH REPORT**
Information on patent family members

| International application No. |
| --- |
| **PCT/JP2023/002257** |

| Patent document cited in search report | | | Publication date (day/month/year) | Patent family member(s) | | | Publication date (day/month/year) |
| --- | --- | --- | --- | --- | --- | --- | --- |
| JP | 2003-161768 | A | 06 June 2003 | (Family: none) | | | |
| JP | 2008-74257 | A | 03 April 2008 | (Family: none) | | | |
| JP | 6430054 | B1 | 28 November 2018 | JP | 2019-203719 | A | |
| | | | | WO | 2019/225032 | A1 | |
| WO | 2010/001605 | A1 | 07 January 2010 | US | 2011/0004428 | A1 | |
| | | | | CN | 102057289 | A | |
| JP | 2017-219405 | A | 14 December 2017 | (Family: none) | | | |
| JP | 2018-152959 | A | 27 September 2018 | (Family: none) | | | |
| WO | 2011/051997 | A1 | 05 May 2011 | US | 2011/0273135 | A1 | |
| | | | | EP | 2348569 | A1 | |
| | | | | CN | 102150316 | A | |
| | | | | KR | 10-2012-0083211 | A | |
| WO | 2020/066290 | A1 | 02 April 2020 | US | 2021/0167363 | A1 | |
| JP | 2001-91605 | A | 06 April 2001 | (Family: none) | | | |
| CN | 103529399 | A | 22 January 2014 | (Family: none) | | | |
| CN | 112290637 | A | 29 January 2021 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H2288074 A